# EUROPEAN PATENT SPECIFICATION

(11) **EP 2 902 514 B1**
(45) Date of publication and mention of the grant of the patent: **24.10.2018**
(21) Application number: 13840429.8
(22) Date of filing: 10.09.2013
(51) Int. Cl.: C22C 1/08, B22F 3/11, C22C 19/03, H01M 4/66, H01M 4/80, H01M 8/02, C25D 5/12, H01M 4/86, H01M 4/88, C23C 18/16, C25D 1/08, C25D 5/14, C25D 5/50, H01B 1/02, H01G 9/00, C22C 19/05, C23C 16/56, H01G 11/68, H01G 11/70

(54) **METALLIC POROUS BODY, AND METHOD FOR PRODUCING SAME**
METALLISCHER PORÖSER KÖRPER UND HERSTELLUNGSVERFAHREN DAFÜR
CORPS POREUX MÉTALLIQUE ET SON PROCÉDÉ DE FABRICATION

(30) Priority: 27.09.2012 JP 2012213791
(43) Date of publication of application: 05.08.2015
(73) Proprietor: Sumitomo Electric Industries, Ltd., Osaka-shi, Osaka 541-0041 (JP); Sumitomo Electric Toyama Co., Ltd., Imizu-shi Toyama 934-0031 (JP)
(72) Inventor: OKUNO, Kazuki, Itami-shi Hyogo 664-0016 (JP); KATO, Masahiro, Itami-shi Hyogo 664-0016 (JP); AWAZU, Tomoyuki, Itami-shi Hyogo 664-0016 (JP); MAJIMA, Masatoshi, Itami-shi Hyogo 664-0016 (JP); TSUKAMOTO, Kengo, Imizu-shi Toyama 934-0031 (JP); TSUCHIDA, Hitoshi, Imizu-shi Toyama 934-0031 (JP); SAITO, Hidetoshi, Imizu-shi Toyama 934-0031 (JP)
(74) Representative: Hoffmann Eitle
(86) International application number: PCT/JP2013/074334
(87) International publication number: WO 2014/050536

(56) References cited:
- JP-A- H0 820 831
- JP-A- S5 518 579
- JP-A- S5 518 579
- JP-A- 2012 149 282
- US-A- 4 272 290
- Marize Varella De Oliveira ET AL: "Porosity Study of Sintered Titanium Foams", Materials Science Forum, vol. 530-531, 1 January 2006 (2006-01-01), pages 22-28, XP055407200, DOI: 10.4028/www.scientific.net/MSF.530-531.22

## Description

### Technical Field

The present invention relates to porous metal bodies that can be used for collectors of various batteries, capacitors, fuel cells, and the like as defined in the claims.

### Background Art

Conventionally, there is a known method of producing a porous metal body in which a porous resin body is made electrically conductive, an electroplating layer composed of metal is formed on the resultant body, and the porous resin body is optionally removed by incineration. For example, this is described in Patent Literature 1.

In addition, porous metal bodies composed of nickel-tin alloys have been proposed as porous metal bodies that have oxidation resistance, corrosion resistance, and high porosity and are suitable for collectors of various batteries, capacitors, fuel cells, and the like. For example, this is described in Patent Literature 2. Furthermore, a porous metal body composed of a nickel-chromium alloy has been proposed as a porous metal body that has high corrosion resistance. For example, this is described in Patent Literature 3. A ternary porous metal body comprising nickel, tin and chromium is disclosed in Patent Literature 4.

However, in recent years, there has been an increasing demand for a higher power and a higher capacity (smaller size) in various batteries, capacitors, fuel cells, and the like. With this demand, there has also been a demand for higher oxidation resistance and corrosion resistance in porous metal bodies constituting collectors.

### Citation List

### Patent Literature

[PTL 1] Japanese Unexamined Patent Application Publication No. 11-154517
[PTL 2] Japanese Unexamined Patent Application Publication No. 2012-132083
[PTL 3] Japanese Unexamined Patent Application Publication No. 2012-149282
[PTL 4] US Patent Application Publication No. 4 272 290 A

### Summary of Invention

### Technical Problem

An object of the present invention is to provide a porous metal body having higher corrosion resistance than existing porous metal bodies composed of nickel-tin binary alloys and existing porous metal bodies composed of nickel-chromium binary alloys.

### Solution to Problem

The inventors have found that the above-described object is achieved by employing a feature (1) of a porous metal body containing at least nickel, tin, and chromium as defined in claim 1.

Note that, in the above-described feature (1), the porous metal body may contain, in addition to nickel, tin, and chromium, one or more other additional elements intentionally or unavoidably as long as the above-described object can be achieved.

In the present invention, the above-described feature (1) is desirably combined with the following feature (2).
(2) In the porous metal body described in (1) above, a weight ratio of chromium contained in the porous metal body to the porous metal body is desirably 5 wt% or more and 20 wt% or less.
   The inventors have found that porous metal bodies satisfying the above-described object can be produced by employing the following features (6) to (16).
(6) A method of producing a porous metal body desirably includes a conductive-coating-layer formation step of forming a conductive coating layer containing chromium on a surface of a porous base formed of a resin material; a metal-layer formation step of forming a nickel layer and a tin layer in any order on a surface of the conductive coating layer; a removal step of removing the porous base; and a diffusion step of, by a heat treatment, causing interdiffusion of metal atoms between the nickel layer and the tin layer and diffusing chromium contained in the conductive coating layer into the nickel layer and the tin layer.
(7) A method of producing a porous metal body desirably includes a conductive-coating-layer formation step of forming a conductive coating layer containing tin on a surface of a porous base formed of a resin material; a metal-layer formation step of forming a nickel layer and a chromium layer in any order on a surface of the conductive coating layer; a removal step of removing the porous base; and a diffusion step of, by a heat treatment, causing interdiffusion of metal atoms between the nickel layer and the chromium layer and diffusing tin contained in the conductive coating layer into the nickel layer and the chromium layer.
(8) A method of producing a porous metal body desirably includes a conductive-coating-layer formation step of forming a conductive coating layer containing tin and chromium on a surface of a porous base formed of a resin material; a metal-layer formation step of forming a nickel layer on a surface of the conductive coating layer; a removal step of removing the porous base; and a diffusion step of, by a heat treatment, diffusing tin and chromium contained in the conductive coating layer into the nickel layer.
(9) A method of producing a porous metal body desirably includes a conductive-coating-layer formation step of forming a conductive coating layer on a surface of a porous base formed of a resin material; a metal-layer formation step of forming a nickel layer, a tin layer, and a chromium layer in any order on a surface of the conductive coating layer; a removal step of removing the porous base; and a diffusion step of, by a heat treatment, causing interdiffusion of metal atoms between the nickel layer, the tin layer, and the chromium layer.
(10) A method of producing a porous metal body desirably includes a conductive-coating-layer formation step of forming a conductive coating layer on a surface of a porous base formed of a resin material; a metal-layer formation step of forming a nickel-tin alloy layer and a chromium layer in any order on a surface of the conductive coating layer; a removal step of removing the porous base; and a diffusion step of, by a heat treatment, causing interdiffusion of metal atoms between the nickel-tin alloy layer and the chromium layer.
(11) A method of producing a porous metal body desirably includes a conductive-coating-layer formation step of forming a conductive coating layer on a surface of a porous base formed of a resin material; a metal-layer formation step of forming a nickel-chromium alloy layer and a tin layer in any order on a surface of the conductive coating layer; a removal step of removing the porous base; and a diffusion step of, by a heat treatment, causing interdiffusion of metal atoms between the nickel-chromium alloy layer and the tin layer.
(12) A method of producing a porous metal body desirably includes a conductive-coating-layer formation step of forming a conductive coating layer containing tin on a surface of a porous base formed of a resin material; a metal-layer formation step of forming a nickel-chromium alloy layer on a surface of the conductive coating layer; a removal step of removing the porous base; and a diffusion step of, by a heat treatment, diffusing tin contained in the conductive coating layer into the nickel-chromium alloy layer.
(13) A method of producing a porous metal body desirably includes a conductive-coating-layer formation step of forming a conductive coating layer containing chromium on a surface of a porous base formed of a resin material; a metal-layer formation step of forming a nickel-tin alloy layer on a surface of the conductive coating layer; a removal step of removing the porous base; and a diffusion step of, by a heat treatment, diffusing chromium contained in the conductive coating layer into the nickel-tin alloy layer.
(14) A method of producing a porous metal body desirably includes a conductive-coating-layer formation step of forming a conductive coating layer on a surface of a porous base formed of a resin material; a metal-layer formation step of forming a nickel-tin-chromium alloy layer on a surface of the conductive coating layer; and a removal step of removing the porous base.
(15) A method of producing a porous metal body desirably includes a conductive-coating-layer formation step of forming a conductive coating layer on a surface of a porous base formed of a resin material; a metal-layer formation step of forming a nickel layer and a tin layer in any order on a surface of the conductive coating layer; a removal step of removing the porous base; and, after the removal step is performed to remove the porous base, a chromizing-treatment step of performing a chromizing treatment.
(16) A method of producing a porous metal body desirably includes a conductive-coating-layer formation step of forming a conductive coating layer containing tin on a surface of a porous base formed of a resin material; a metal-layer formation step of forming a nickel layer on a surface of the conductive coating layer; a removal step of removing the porous base; and, after the removal step is performed to remove the porous base, a chromizing-treatment step of performing a chromizing treatment.

### Advantageous Effects of Invention

The present invention can provide a porous metal body having higher corrosion resistance than existing porous metal bodies composed of nickel-tin binary alloys and existing porous metal bodies composed of nickel-chromium binary alloys.

### Brief Description of Drawings

[Fig. 1] Figure 1 illustrates relationships between potential with reference to a standard hydrogen electrode and a current value in the case of performing a corrosion resistance test based on American Society for Testing and Materials (ASTM) G5-94 one time for Examples 1 and 2 and Comparative examples 1 and 2.
[Fig. 2] Figure 2 illustrates relationships between potential with reference to a standard hydrogen electrode and a current value in the case of performing a corrosion resistance test based on ASTM G5-94 one time and five times for Example 1.
[Fig. 3] Figure 3 illustrates relationships between potential with reference to a standard hydrogen electrode and a current value in the case of performing a corrosion resistance test based on ASTM G5-94 one time and five times for Example 2.
[Fig. 4] Figure 4 illustrates relationships between potential with reference to a standard hydrogen electrode and a current value in the case of performing a corrosion resistance test based on ASTM G5-94 one time and five times for Comparative example 2.

### Description of Embodiments

By employing a weight ratio of tin contained in the porous metal body to the porous metal body is desirably 5 wt% or more and 25 wt% or less, the oxidation resistance and the corrosion resistance are enhanced and generation of a nickel-tin intermetallic compound having a low strength and being brittle is suppressed. Thus, a porous metal body having a high strength can be obtained. When the weight ratio of tin contained in the porous metal body to the porous metal body is less than 5 wt%, the oxidation resistance and the corrosion resistance become insufficient. When the weight ratio of tin contained in the porous metal body to the porous metal body is more than 25 wt%, a nickel-tin intermetallic compound having a low strength and being brittle is generated and the porous metal body becomes brittle.

By employing a weight ratio of chromium contained in the porous metal body to the porous metal body is 1 wt% or more and 45 wt% or less, desirably 5 wt% or more and 20 wt% or less, the oxidation resistance and the corrosion resistance can be enhanced. When the weight ratio of chromium contained in the porous metal body to the porous metal body is less than 1 wt%, the oxidation resistance and the corrosion resistance become insufficient. When the weight ratio of chromium contained in the porous metal body to the porous metal body is more than 45 wt%, the electric resistance is decreased.

In particular, in the porous metal body defined in claim 1, in the case where the weight ratio of tin contained in the porous metal body to the porous metal body is 5 wt% or more and 25 wt% or less and the weight ratio of chromium contained in the porous metal body to the porous metal body is 1 wt% or more and 25 wt% or less, the porous metal body has significant advantages of having high oxidation resistance and high corrosion resistance with stability and having a low electric resistance.

When the porous metal body contains, as an additional element, at least one element selected from the group consisting of phosphorus, boron, aluminum, titanium, manganese, cobalt, copper, molybdenum, and tungsten, and , when the weight ratio of the additional element to the porous metal body is more than 15 wt%, the oxidation resistance and the corrosion resistance are degraded.

Since the porous metal body is a metal structural body having a three-dimensional network skeleton, the porous metal body can be easily made to have a high porosity.

In each metal-layer formation step in (6) and (15) above, the nickel layer and the tin layer can be formed in any order and the order of forming these metal layers can be appropriately changed.

In the metal-layer formation step in (7) above, the nickel layer and the chromium layer can be formed in any order and the order of forming these metal layers can be appropriately changed.

In the metal-layer formation step in (9) above, the nickel layer, the tin layer, and the chromium layer can be formed in any order and the order of forming these metal layers can be appropriately changed.

In the metal-layer formation step in (10) above, the nickel-tin alloy layer and the chromium layer can be formed in any order and the order of forming these metal layers can be appropriately changed.

In the metal-layer formation step in (11) above, the nickel-chromium alloy layer and the tin layer can be formed in any order and the order of forming these metal layers can be appropriately changed.

In (14) above, if necessary, a step of causing diffusion of metal atoms within the nickel-tin-chromium alloy layer by a heat treatment may be performed. However, when nickel, tin, and chromium are uniformly distributed within the nickel-tin-chromium alloy layer formed in the metal-layer formation step, the step of causing diffusion of metal atoms may be omitted.

When each removal step in (6) to (13), (15), and (16) above is a step of incinerating the porous base by a heat treatment, and the heat-treatment temperature of the removal step and the heat-treatment temperature of the diffusion step can be set to the same temperature, the diffusion step can also function as the removal step (in the diffusion step, the porous base can be removed by incineration).

In each metal-layer formation step in (6), (7), (10), (11), and (15) above, the removal step may be performed during the metal-layer formation step. Specifically, after the first metal layer is formed and the porous base is removed, the second metal layer may be formed. In (15) above, the chromizing-treatment step is not necessarily performed immediately after the removal step. The latter part (step of forming the second metal layer) of the metal-layer formation step may be performed between the removal step and the chromizing-treatment step.

Regarding the metal-layer formation step in (9) above, the removal step may be performed during the metal-layer formation step. Specifically, the porous base may be removed between the formation of the first metal layer and the formation of the second metal layer. Alternatively, the porous base may be removed between the formation of the second metal layer and the formation of the third metal layer.

In (6) to (16) above, regarding the "porous base formed of a resin material", a porous resin material that is publicly known or commercially available can be employed. Specific examples of the porous base formed of a resin material include a foam formed of a resin material, nonwoven fabric formed of a resin material, felt formed of a resin material, a three-dimensional network structural body formed of a resin material, and a combination of the foregoing. The type of the resin material constituting the porous base is not particularly limited; however, resin materials that can be removed by incineration are desirable. Specific examples of a foam formed of a resin material include a urethane foam, a styrene foam, and a melamine-resin foam. In order to provide a porous base having a high porosity, for example, a urethane foam is desirable. When the porous base has a sheet-like shape, it is desirably a flexible member (not broken when bent) in view of handleability.

The porosity of the porous base is not limited and is appropriately selected in accordance with the application; in general, the porosity is 60% or more and 98% or less, preferably 80% or more and 96% or less.

The thickness of the porous base is not limited and is appropriately selected in accordance with the application; in general, the thickness is 150 µm or more and 5000 µm or less, preferably 200 µm or more and 2000 µm or less, more preferably 300 µm or more and 1200 µm or less.

In (9) to (11), (14), and (15) above, the "conductive-coating-layer formation step of forming a conductive coating layer on a surface of a porous base formed of a resin material" can be performed by various processes as long as a conductive layer can be formed on the surface of the porous base. Specific examples of the "conductive-coating-layer formation step of forming a conductive coating layer on a surface of a porous base formed of a resin material" include a process of coating the surface of the porous base with a mixture of a binder and a conductive powder (for example, a powder of a metal material such as stainless steel; or a powder of a carbon such as crystalline graphite or amorphous carbon black), or a process of forming a layer composed of a metal material such as nickel on the surface of the porous base by electro less plating, sputtering, vapor deposition, ion-plating, or the like.

Specific examples of electroless plating with nickel include a process of immersing a porous base into a publicly known electroless nickel plating bath such as a nickel sulfate aqueous solution containing sodium hypophosphite. If necessary, prior to the immersion into the plating bath, the porous base may be immersed into an activation solution containing a small amount of palladium ions (a cleaning solution manufactured by JAPAN KANIGEN CO., LTD.).

Specific examples of sputtering with nickel include a process of fixing a porous base on a substrate holder and, under introduction of an inert gas, applying a direct voltage between the substrate holder and a target (nickel) to thereby make ionized inert gas impinge onto the nickel and deposit the sputtered nickel particles onto the surface of the porous base.

As long as the conductive coating layer is continuously formed (so as to be electrically continuous) on the surface of the porous base, the coating weight of the conductive coating layer (amount of adhesion to the porous base) is not limited. For example, when the conductive coating layer is formed of nickel, the coating weight is generally 5 g/m² or more and 15 g/m² or less, preferably 7 g/m² or more and 10 g/m² or less.

In (6) and (13) above, the "conductive-coating-layer formation step of forming a conductive coating layer containing chromium on a surface of a porous base formed of a resin material" can be performed by various processes as long as a conductive layer containing chromium can be formed on the surface of the porous base. Specific examples of the "conductive-coating-layer formation step of forming a conductive coating layer containing chromium on a surface of a porous base formed of a resin material" include a process (A1) of coating the surface of the porous base with a mixture of a chromium-containing powder (for example, chromium powder or chromium oxide powder) and a binder; a process (B1) of coating the surface of the porous base with a mixture of a chromium-containing powder, a conductive powder (a powder of a metal material such as stainless steel or a powder of carbon or the like), and a binder; and a process (C1) of forming a layer composed of chromium or a chromium alloy on the surface of the porous base by electro less plating, sputtering, vapor deposition, ion-plating, or the like.

In (7) and (12) above, the "conductive-coating-layer formation step of forming a conductive coating layer containing tin on a surface of a porous base formed of a resin material" can be performed by various processes as long as a conductive layer containing tin can be formed on the surface of the porous base. Specific examples of the "conductive-coating-layer formation step of forming a conductive coating layer containing tin on a surface of a porous base formed of a resin material" include a process (A2) of coating the surface of the porous base with a mixture of a tin-containing powder (for example, tin powder or tin oxide powder) and a binder; a process (B2) of coating the surface of the porous base with a mixture of a tin-containing powder, a conductive powder (a powder of a metal material such as stainless steel or a powder of carbon or the like), and a binder; and a process (C2) of forming a layer composed of tin or a tin alloy on the surface of the porous base by electro less plating, sputtering, vapor deposition, ion-plating, or the like.

In (8) above, the "conductive-coating-layer formation step of forming a conductive coating layer containing tin and chromium on a surface of a porous base formed of a resin material" can be performed by various processes as long as a conductive layer containing tin and chromium can be formed on the surface of the porous base.

Specific examples of the "conductive-coating-layer formation step of forming a conductive coating layer containing tin and chromium on a surface of a porous base formed of a resin material" include a process (A3) of coating the surface of the porous base with a mixture of a tin-containing powder, a chromium-containing powder, and a binder; a process (B3) of coating the surface of the porous base with a mixture of a tin-containing powder, a chromium-containing powder, a conductive powder (a powder of a metal material such as stainless steel or a powder of carbon or the like), and a binder; and a process (C3) of forming a tin layer and a chromium layer in any order or a tin-chromium alloy layer, on the surface of the porous base by electroless plating, sputtering, vapor deposition, ion-plating, or the like.

### [Examples]

### (Example 1)

Hereinafter, Example 1 will be described in detail. Example 1 is a nickel-tin-chromium-alloy porous body and serves as an embodiment of the present invention.

### (Conductive treatment of three-dimensional network resin)

A polyurethane foam sheet having a thickness of 1.5 mm (pore size: 0.45 mm) was first prepared as a three-dimensional network resin (an embodiment of the porous base formed of a resin material). Subsequently, 90 g of graphite having a volume-average particle size of 0.5 µm and 12 g of chromium particles having a volume-average particle size of 5 µm were dispersed in 0.5 L of 10 mass% aqueous solution of an acrylic ester-based resin to prepare, at these proportions, an adhesive coating material.

The polyurethane foam sheet was subsequently made electrically conductive by being continuously immersed in the coating material, squeezed with a roll, and then dried. Thus, a conductive coating layer was formed on the surface of the three-dimensional network resin. Note that the viscosity of the conductive coating material was adjusted with a thickener such that the coating weight of the conductive coating material after drying was to be 69 g/m² to thereby achieve a target alloy composition.

As a result of this step, a coating film of the conductive coating material containing carbon powder and chromium particles is formed on the surface of the three-dimensional network resin.

### (Metal plating step)

Onto the three-dimensional network resin having been made electrically conductive, nickel was deposited at 300 g/m² and tin was then deposited at 42 g/m² by electroplating to form an electroplating layer (an embodiment of the nickel layer and the tin layer). The plating solutions used were a nickel sulfamate plating solution for nickel and a sulfate bath for tin.

As a result of this step, a nickel plating layer and a tin plating layer are formed on the coating film of the conductive coating material containing carbon powder and chromium particles.

### (Heat-treatment step)

The porous metal body obtained in the above-described step was first subjected to a heat treatment in the air at 800°C for 15 minutes to thereby incinerate the three-dimensional network resin and the binder (an embodiment of the removal step). After that, the porous metal body was subjected to a heat treatment in a hydrogen atmosphere at 1000°C for 50 minutes to thereby reduce metals having been oxidized in the heat treatment in the air and cause alloying through thermal diffusion (an embodiment of the diffusion step).

As a result of this step, the three-dimensional network resin is removed through decomposition by heating. The chromium particles contained in the conductive coating layer, the nickel plating layer, and the tin plating layer are reduced by carbon powder contained in the conductive coating layer. In addition, the chromium component contained in the conductive coating layer, the nickel plating layer, and the tin plating layer are alloyed through thermal diffusion. Finally, a porous alloy body having a thickness of 1.5 mm, a coating weight of 350 g/m², a nickel content of 86%, a tin content of 12%, and a chromium content of 2% was obtained.

### (Example 2)

Hereinafter, Example 2 will be described in detail. Example 2 is a nickel-chromium-tin-alloy porous body and serves as an embodiment of the present invention. Example 2 was basically produced by the same procedures as in Example 1. Finally, the thickness was 1.5 mm; the coating weight was 350 g/m²; and, in the composition, the nickel content was 76%, the tin content was 12%, and the chromium content was 12%.

### (Comparative example 1)

Hereinafter, a nickel-tin-alloy porous body serving as Comparative example 1 will be described in detail.

### (Conductive treatment of three-dimensional network resin)

A polyurethane foam sheet having a thickness of 1.5 mm (pore size: 0.45 mm) was first prepared as a three-dimensional network resin. Subsequently, 90 g of graphite having a volume-average particle size of 0.5 µm was dispersed in 0.5 L of 10 mass% aqueous solution of an acrylic ester-based resin to prepare, at this proportion, an adhesive coating material.

The polyurethane foam sheet was subsequently made electrically conductive by being continuously immersed in the coating material, squeezed with a roll, and then dried. Thus, a conductive coating layer was formed on the surface of the three-dimensional network resin. Note that the viscosity of the conductive coating material was adjusted with a thickener such that the coating weight of the conductive coating material after drying was to be 55 g/m² to thereby achieve a target alloy composition.

As a result of this step, a coating film of the conductive coating material containing carbon powder is formed on the surface of the three-dimensional network resin.

### (Metal plating step)

Onto the three-dimensional network resin having been made electrically conductive, nickel was deposited at 300 g/m² and tin was deposited at 53 g/m² by electroplating to form an electroplating layer. The plating solutions used were a nickel sulfamate plating solution for nickel and a sulfate bath for tin.

As a result of this step, a nickel plating layer and a tin plating layer are formed on the coating film of the conductive coating material containing carbon powder.

### (Heat-treatment step)

The porous metal body obtained in the above-described step was first subjected to a heat treatment in the air at 800°C for 15 minutes to thereby incinerate the three-dimensional network resin and the binder. After that, the porous metal body was subjected to a heat treatment in a hydrogen atmosphere at 1000°C for 50 minutes to thereby reduce metals having been oxidized in the heat treatment in the air and cause alloying through thermal diffusion.

As a result of this step, the three-dimensional network resin is removed through decomposition by heating. The nickel plating layer and the tin plating layer are reduced by carbon powder contained in the conductive coating layer and are alloyed through thermal diffusion. Finally, a porous alloy body having a thickness of 1.5 mm, a coating weight of 350 g/m², a nickel content of 85%, and a tin content of 15% was obtained.

### (Comparative example 2)

Hereinafter, a nickel-chromium-alloy porous body serving as Comparative example 2 will be described in detail.

### (Conductive treatment of three-dimensional network resin)

A polyurethane foam sheet having a thickness of 1.5 mm (pore size: 0.45 mm) was first prepared as a three-dimensional network resin. Subsequently, 90 g of graphite having a volume-average particle size of 0.5 µm was dispersed in 0.5 L of 10 mass% aqueous solution of an acrylic ester-based resin to prepare, at this proportion, an adhesive coating material.

The polyurethane foam sheet was subsequently made electrically conductive by being continuously immersed in the coating material, squeezed with a roll, and then dried. Thus, a conductive coating layer was formed on the surface of the three-dimensional network resin. Note that the viscosity of the conductive coating material was adjusted with a thickener such that the coating weight of the conductive coating material after drying was to be 55 g/m² to thereby achieve a target alloy composition.

As a result of this step, a coating film of the conductive coating material containing carbon powder is formed on the surface of the three-dimensional network resin.

### (Metal plating step)

Onto the three-dimensional network resin having been made electrically conductive, nickel was deposited at 300 g/m² by electroplating to form an electroplating layer. The plating solution used was a nickel sulfamate plating solution for nickel.

As a result of this step, a nickel plating layer is formed on the coating film of the conductive coating material containing carbon powder.

### (Heat-treatment step)

The porous metal body obtained in the above-described step was first subjected to a heat treatment in the air at 800°C for 15 minutes to thereby incinerate the three-dimensional network resin and the binder. After that, the porous metal body was subjected to a heat treatment in a hydrogen atmosphere at 1000°C for 50 minutes to thereby reduce metal having been oxidized in the heat treatment in the air.

As a result of this step, the three-dimensional network resin is removed through decomposition by heating. The nickel plating layer is reduced by carbon powder contained in the conductive coating layer.

### (Chromium diffusion step)

The porous nickel body obtained in the above-described step was subjected to a chromizing treatment (powder pack method) to diffuse chromium therein. The porous nickel body was filled with a cementation material (chromium: 90 wt%, NH₄Cl: 1 wt%, Al₂O₃: 9 wt%) prepared by mixing chromium powder, ammonium chloride, and alumina powder, and heated in a hydrogen gas atmosphere at 800°C to thereby provide a nickel-chromium-alloy porous body.

In the above-described chromizing treatment, the time for heating in the chromizing treatment was adjusted to finally provide a porous alloy body having a thickness of 1.5 mm, a coating weight of 460 g/m², a nickel content of 65%, and a chromium content of 35%.

### (Corrosion resistance test)

As a technique of evaluating the obtained porous metal bodies in terms of corrosion resistance, a test based on ASTM G5-94 was performed. An acidic aqueous solution used in the anodic polarization curve measurement was prepared as 1 mol/L sodium sulfate aqueous solution having been subjected to pH adjustment with sulfuric acid. The test temperature was 60°C. During the test, hydrogen bubbling was performed to provide hydrogen saturation state. In voltammetry, the potential with reference to a standard hydrogen electrode was swept from 0 V to 1.0 V, which is probably actually applied in a fuel cell, at a rate of 5 mV/s.

### (Test results 1)

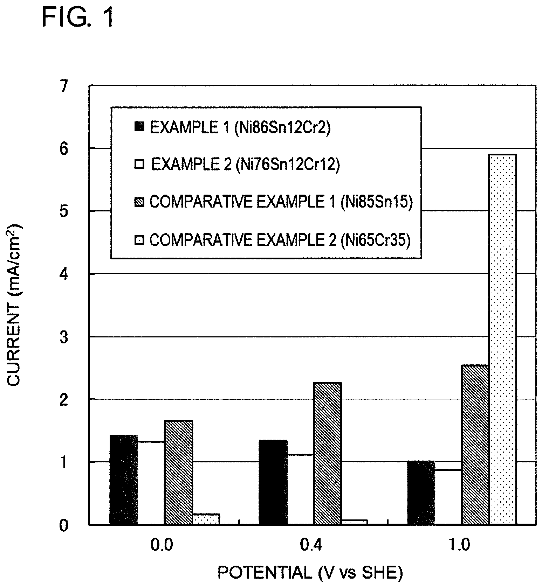

Figure 1 illustrates a plot of current values at representative potentials of 0.0 V, 0.4 V, and 1.0 V. The currents were normalized on the basis of the apparent areas of the samples. In Fig. 1, the abscissa axis indicates potential with reference to the standard hydrogen electrode, and the ordinate axis indicates values obtained by normalizing current values of measurement samples on the basis of the apparent areas of the samples.

As illustrated in Fig. 1, Examples 1 and 2 have lower current values at 0 V, 0.4 V, and 1.0 V than Comparative example 1 and thus have high corrosion resistance. Compared with Comparative example 2, Examples 1 and 2 have high current values at 0 V and 0.4 V, but have current values at 1.0 V that are about 1/5 of that of Comparative example 2 and thus have high corrosion resistance on the high voltage side.

### (Test results 2)

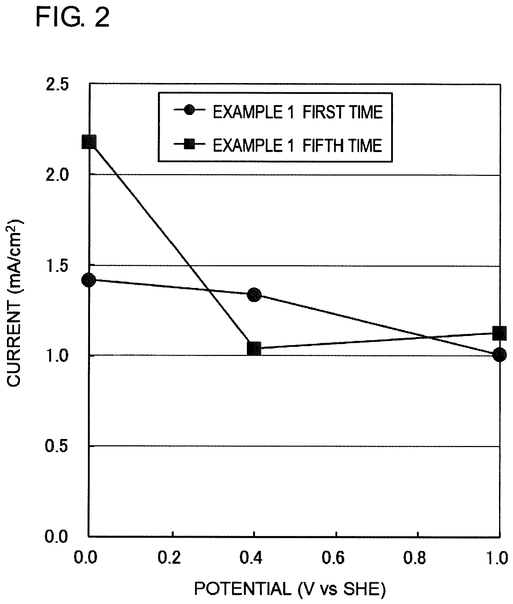

In order to compare Examples 1 and 2 and Comparative example 2 in terms of durability, the corrosion resistance test described in the Test results 1 was repeated five times and changes in current values were measured. The measurement results are illustrated in Figs. 2 to 4.

In Figs. 2 to 4, the abscissa axis indicates potential with reference to the standard hydrogen electrode, and the ordinate axis indicates values obtained by normalizing current values of measurement samples on the basis of the apparent areas of the samples.

As illustrated in Fig. 2, in Example 1, in repeated corrosion resistance tests, the current value at 0.4 V decrease, which indicates enhancement of corrosion resistance.

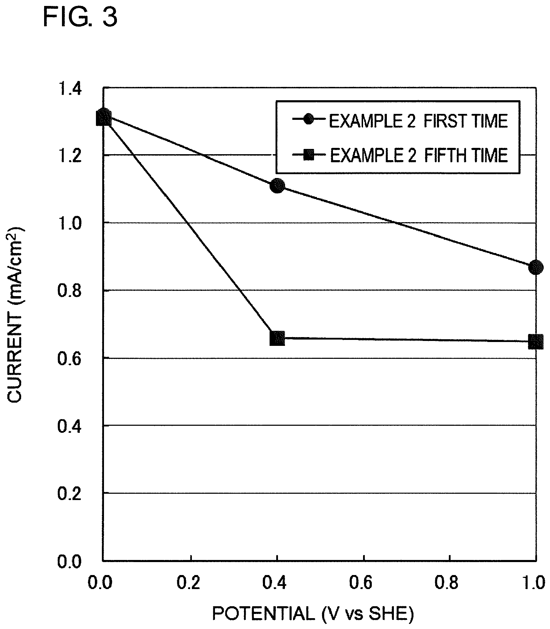

As illustrated in Fig. 3, in Example 2, the current values at 0 V do not considerably change during repeated corrosion resistance tests, whereas the current values at 0.4 V and 1.0 V decrease, which indicates enhancement of corrosion resistance.

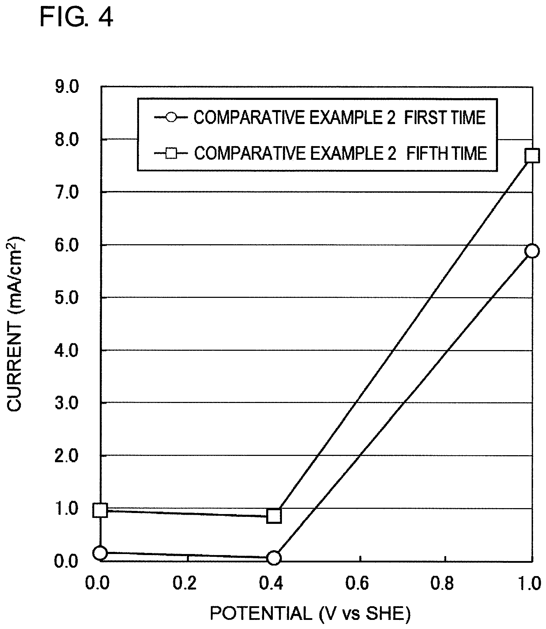

On the other hand, as illustrated in Fig. 4, in the same tests for Comparative example 2, current values increase at all the potentials of 0 V, 0.4 V, and 1.0 V and thus the corrosion resistance is degraded. The tests indicate that Examples 1 and 2 have higher durability than Comparative example 2.

Test results 1 and 2 indicate that, particularly in the application of a fuel cell in which the voltage becomes constant at about 1.0 V during operation, Examples 1 and 2 have higher corrosion resistance than Comparative examples 1 and 2 and are useful.

## Claims

1. A nickel-tin-chromium alloy porous metal body for a collector in a battery, a capacitator or a fuel cell comprising nickel, tin, and chromium, and, optionally as an additional element, at least one element selected from the group consisting of phosphorus, boron, aluminum, titanium, manganese, cobalt, copper, molybdenum, and tungsten,
wherein a weight ratio of the additional element to the porous metal body is 15 wt% or less,
wherein a weight ratio of tin contained in the porous metal body to the porous metal body is 12 wt% or more and 25 wt% or less,
wherein a weight ratio of chromium contained in the porous metal body to the porous metal body is 1 wt% or more and 45 wt% or less, and
wherein the porous metal body is a metal structural body having a three-dimensional network skeleton.

2. The nickel-tin-chromium alloy porous metal body according to Claim 1, wherein
a weight ratio of chromium contained in the porous metal body to the porous metal body is 5 wt% or more and 20 wt% or less.

3. A method of producing the nickel-tin-chromium alloy porous metal body according to any one of Claims 1 to 2, comprising:
a conductive-coating-layer formation step of forming a conductive coating layer containing chromium on a surface of a porous base formed of a resin material;
a metal-layer formation step of forming a nickel layer and a tin layer in any order on a surface of the conductive coating layer;
a removal step of removing the porous base; and
a diffusion step of, by a heat treatment, causing interdiffusion of metal atoms between the nickel layer and the tin layer and diffusing chromium contained in the conductive coating layer into the nickel layer and the tin layer.

4. A method of producing the nickel-tin-chromium alloy porous metal body according to any one of Claims 1 to 2, comprising:
a conductive-coating-layer formation step of forming a conductive coating layer containing tin on a surface of a porous base formed of a resin material;
a metal-layer formation step of forming a nickel layer and a chromium layer in any order on a surface of the conductive coating layer;
a removal step of removing the porous base; and
a diffusion step of, by a heat treatment, causing interdiffusion of metal atoms between the nickel layer and the chromium layer and diffusing tin contained in the conductive coating layer into the nickel layer and the chromium layer.

5. A method of producing the nickel-tin-chromium alloy porous metal body according to any one of Claims 1 to 2, comprising:
a conductive-coating-layer formation step of forming a conductive coating layer containing tin and chromium on a surface of a porous base formed of a resin material;
a metal-layer formation step of forming a nickel layer on a surface of the conductive coating layer;
a removal step of removing the porous base; and
a diffusion step of, by a heat treatment, diffusing tin and chromium contained in the conductive coating layer into the nickel layer.

6. A method of producing the nickel-tin-chromium alloy porous metal body according to any one of Claims 1 to 2, comprising:
a conductive-coating-layer formation step of forming a conductive coating layer on a surface of a porous base formed of a resin material;
a metal-layer formation step of forming a nickel layer, a tin layer, and a chromium layer in any order on a surface of the conductive coating layer;
a removal step of removing the porous base; and
a diffusion step of, by a heat treatment, causing interdiffusion of metal atoms between the nickel layer, the tin layer, and the chromium layer.

7. A method of producing the nickel-tin-chromium alloy porous metal body according to any one of Claims 1 to 2, comprising:
a conductive-coating-layer formation step of forming a conductive coating layer on a surface of a porous base formed of a resin material;
a metal-layer formation step of forming a nickel-tin alloy layer and a chromium layer in any order on a surface of the conductive coating layer;
a removal step of removing the porous base; and
a diffusion step of, by a heat treatment, causing interdiffusion of metal atoms between the nickel-tin alloy layer and the chromium layer.

8. A method of producing the nickel-tin-chromium alloy porous metal body according to any one of Claims 1 to 2, comprising:
a conductive-coating-layer formation step of forming a conductive coating layer on a surface of a porous base formed of a resin material;
a metal-layer formation step of forming a nickel-chromium alloy layer and a tin layer in any order on a surface of the conductive coating layer;
a removal step of removing the porous base; and
a diffusion step of, by a heat treatment, causing interdiffusion of metal atoms between the nickel-chromium alloy layer and the tin layer.

9. A method of producing the nickel-tin-chromium alloy porous metal body according to any one of Claims 1 to 2, comprising:
a conductive-coating-layer formation step of forming a conductive coating layer containing tin on a surface of a porous base formed of a resin material;
a metal-layer formation step of forming a nickel-chromium alloy layer on a surface of the conductive coating layer;
a removal step of removing the porous base; and
a diffusion step of, by a heat treatment, diffusing tin contained in the conductive coating layer into the nickel-chromium alloy layer.

10. A method of producing the nickel-tin-chromium alloy porous metal body according to any one of Claims 1 to 2, comprising:
a conductive-coating-layer formation step of forming a conductive coating layer containing chromium on a surface of a porous base formed of a resin material;
a metal-layer formation step of forming a nickel-tin alloy layer on a surface of the conductive coating layer;
a removal step of removing the porous base; and
a diffusion step of, by a heat treatment, diffusing chromium contained in the conductive coating layer into the nickel-tin alloy layer.

11. A method of producing the nickel-tin-chromium alloy porous metal body according to any one of Claims 1 to 2, comprising:
a conductive-coating-layer formation step of forming a conductive coating layer on a surface of a porous base formed of a resin material;
a metal-layer formation step of forming a nickel-tin-chromium alloy layer on a surface of the conductive coating layer; and
a removal step of removing the porous base.

12. A method of producing the nickel-tin-chromium alloy porous metal body according to any one of Claims 1 to 2, comprising:
a conductive-coating-layer formation step of forming a conductive coating layer on a surface of a porous base formed of a resin material;
a metal-layer formation step of forming a nickel layer and a tin layer in any order on a surface of the conductive coating layer;
a removal step of removing the porous base; and
after the removal step is performed to remove the porous base, a chromizing-treatment step of performing a chromizing treatment.

13. A method of producing the nickel-tin-chromium alloy porous metal body according to any one of Claims 1 to 2, comprising:
a conductive-coating-layer formation step of forming a conductive coating layer containing tin on a surface of a porous base formed of a resin material;
a metal-layer formation step of forming a nickel layer on a surface of the conductive coating layer;
a removal step of removing the porous base; and
after the removal step is performed to remove the porous base, a chromizing-treatment step of performing a chromizing treatment.

## Patentansprüche

1. Poröser Metallkörper einer Nickel-Zinn-Chromlegierung für einen Kollektor in einer Batterie, einem Kondensator oder einer Brennstoffzelle, umfassend Nickel, Zinn und Chrom und optional als ein zusätzliches Element wenigstens ein Element, ausgewählt aus der Gruppe, bestehend aus Phosphor, Bor, Aluminium, Titan, Mangan, Kobalt, Kupfer, Molybdän und Wolfram,
wobei das Gewichtsverhältnis des zusätzlichen Elements zum porösen Metallkörper 15 Gew.% oder weniger beträgt,
wobei das Gewichtsverhältnis des im porösen Metallkörper enthaltenen Zinns zum porösen Metallkörper 12 Gew.% oder mehr und 25 Gew.% oder weniger beträgt,
wobei das Gewichtsverhältnis des im porösen Metallkörper enthaltenen Chroms zum porösen Metallkörper 1 Gew.% oder mehr und 45 Gew.% oder weniger beträgt, und
wobei der poröse Metallkörper ein struktureller Metallkörper mit einem dreidimensionalen Netzwerkskelett ist.

2. Poröser Metallkörper einer Nickel-Zinn-Chromlegierung gemäß Anspruch 1, wobei das Gewichtsverhältnis des im porösen Metallkörper enthaltenen Chroms zum porösen Metallkörper 5 Gew.% oder mehr und 20 Gew.% oder weniger beträgt.

3. Verfahren zum Herstellen des porösen Metallkörpers einer Nickel-Zinn-Chromlegierung gemäß einem der Ansprüche 1 bis 2, umfassend:
einen Schritt der Bildung einer leitfähigen Beschichtungsschicht, bei dem eine chromhaltige leitfähige Beschichtungsschicht auf einer Fläche einer aus einem Harzmaterial gebildeten porösen Basis gebildet wird;
einen Metallschichtbildungsschritt, bei dem eine Nickelschicht und eine Zinnschicht in einer beliebigen Reihenfolge auf einer Fläche der leitfähigen Beschichtungsschicht gebildet werden;
einen Entfernungsschritt, bei dem die poröse Basis entfernt wird; und
einen Diffusionsschritt, bei dem mittels einer Wärmebehandlung Interdiffusion von Metallatomen zwischen der Nickelschicht und der Zinnschicht und Diffundieren von in der leitfähigen Beschichtungsschicht enthaltenem Chrom in die Nickelschicht und die Zinnschicht herbeigeführt wird.

4. Verfahren zum Herstellen des porösen Metallkörpers einer Nickel-Zinn-Chromlegierung gemäß einem der Ansprüche 1 bis 2, umfassend:
einen Schritt der Bildung einer leitfähigen Beschichtungsschicht, bei dem eine zinnhaltige leitfähige Beschichtungsschicht auf einer Fläche einer aus einem Harzmaterial gebildeten porösen Basis gebildet wird;
einen Metallschichtbildungsschritt, bei dem eine Nickelschicht und eine Chromschicht in einer beliebigen Reihenfolge auf einer Fläche der leitfähigen Beschichtungsschicht gebildet werden;
einen Entfernungsschritt, bei dem die poröse Basis entfernt wird; und
einen Diffusionsschritt, bei dem mittels einer Wärmebehandlung Interdiffusion von Metallatomen zwischen der Nickelschicht und der Chromschicht und Diffundieren von in der leitfähigen Beschichtungsschicht enthaltenem Zinn in die Nickelschicht und die Chromschicht herbeigeführt wird.

5. Verfahren zum Herstellen des porösen Metallkörpers einer Nickel-Zinn-Chromlegierung gemäß einem der Ansprüche 1 bis 2, umfassend:
einen Schritt der Bildung einer leitfähigen Beschichtungsschicht, bei dem eine zinn- und chromhaltige leitfähige Beschichtungsschicht auf einer Fläche einer aus einem Harzmaterial gebildeten porösen Basis gebildet wird;
einen Metallschichtbildungsschritt, bei dem eine Nickelschicht auf einer Fläche der leitfähigen Beschichtungsschicht gebildet wird;
einen Entfernungsschritt, bei dem die poröse Basis entfernt wird; und
einen Diffusionsschritt, bei dem mittels einer Wärmebehandlung in der leitfähigen Beschichtungsschicht enthaltene Zinn und Chrom in die Nickelschicht diffundieren.

6. Verfahren zum Herstellen des porösen Metallkörpers einer Nickel-Zinn-Chromlegierung gemäß einem der Ansprüche 1 bis 2, umfassend:
einen Schritt der Bildung einer leitfähigen Beschichtungsschicht, bei dem eine leitfähige Beschichtungsschicht auf einer Fläche einer aus einem Harzmaterial gebildeten porösen Basis gebildet wird;
einen Metallschichtbildungsschritt, bei dem eine Nickelschicht, eine Zinnschicht und eine Chromschicht in einer beliebigen Reihenfolge auf einer Fläche der leitfähigen Beschichtungsschicht gebildet werden;
einen Entfernungsschritt, bei dem die poröse Basis entfernt wird; und
einen Diffusionsschritt, bei dem mittels einer Wärmebehandlung Interdiffusion von Metallatomen zwischen der Nickelschicht, der Zinnschicht und der Chromschicht herbeigeführt wird.

7. Verfahren zum Herstellen des porösen Metallkörpers einer Nickel-Zinn-Chromlegierung gemäß einem der Ansprüche 1 bis 2, umfassend:
einen Schritt der Bildung einer leitfähigen Beschichtungsschicht, bei dem eine leitfähige Beschichtungsschicht auf einer Fläche einer aus einem Harzmaterial gebildeten porösen Basis gebildet wird;
einen Metallschichtbildungsschritt, bei dem eine Nickel-Zinn-Legierungsschicht und eine Chromschicht in einer beliebigen Reihenfolge auf einer Fläche der leitfähigen Beschichtungsschicht gebildet werden;
einen Entfernungsschritt, bei dem die poröse Basis entfernt wird; und
einen Diffusionsschritt, bei dem mittels einer Wärmebehandlung Interdiffusion von Metallatomen zwischen der Nickel-Zinn-Legierungsschicht und der Chromschicht herbeigeführt wird.

8. Verfahren zum Herstellen des porösen Metallkörpers einer Nickel-Zinn-Chromlegierung gemäß einem der Ansprüche 1 bis 2, umfassend:
einen Schritt der Bildung einer leitfähigen Beschichtungsschicht, bei dem eine leitfähige Beschichtungsschicht auf einer Fläche einer aus einem Harzmaterial gebildeten porösen Basis gebildet wird;
einen Metallschichtbildungsschritt, bei dem eine Nickel-Chrom-Legierungsschicht und eine Zinnschicht in einer beliebigen Reihenfolge auf einer Fläche der leitfähigen Beschichtungsschicht gebildet werden;
einen Entfernungsschritt, bei dem die poröse Basis entfernt wird; und
einen Diffusionsschritt, bei dem mittels einer Wärmebehandlung Interdiffusion von Metallatomen zwischen der Nickel-Chrom-Legierungsschicht und der Zinnschicht herbeigeführt wird.

9. Verfahren zum Herstellen des porösen Metallkörpers einer Nickel-Zinn-Chromlegierung gemäß einem der Ansprüche 1 bis 2, umfassend:
einen Schritt der Bildung einer leitfähigen Beschichtungsschicht, bei dem eine zinnhaltige leitfähige Beschichtungsschicht auf einer Fläche einer aus einem Harzmaterial gebildeten porösen Basis gebildet wird;
einen Metallschichtbildungsschritt, bei dem eine Nickel-Chrom-Legierungsschicht auf einer Fläche der leitfähigen Beschichtungsschicht gebildet wird;
einen Entfernungsschritt, bei dem die poröse Basis entfernt wird; und
einen Diffusionsschritt, bei dem mittels einer Wärmebehandlung in der leitfähigen Beschichtungsschicht enthaltenes Zinn in die Nickel-Chrom-Legierungsschicht diffundiert.

10. Verfahren zum Herstellen des porösen Metallkörpers einer Nickel-Zinn-Chromlegierung gemäß einem der Ansprüche 1 bis 2, umfassend:
einen Schritt der Bildung einer leitfähigen Beschichtungsschicht, bei dem eine chromhaltige Beschichtungsschicht auf einer Fläche einer aus einem Harzmaterial gebildeten porösen Basis gebildet wird;
einen Metallschichtbildungsschritt, bei dem eine Nickel-Zinn-Legierungsschicht auf einer Fläche der leitfähigen Beschichtungsschicht gebildet wird;
einen Entfernungsschritt, bei dem die poröse Basis entfernt wird; und
einen Diffusionsschritt, bei dem mittels einer Wärmebehandlung in der leitfähigen Beschichtungsschicht enthaltenes Chrom in die Nickel-Zinn-Legierungsschicht diffundiert.

11. Verfahren zum Herstellen des porösen Metallkörpers einer Nickel-Zinn-Chromlegierung gemäß einem der Ansprüche 1 bis 2, umfassend:
einen Schritt der Bildung einer leitfähigen Beschichtungsschicht, bei dem eine leitfähige Beschichtungsschicht auf einer Fläche einer aus einem Harzmaterial gebildeten porösen Basis gebildet wird;
einen Metallschichtbildungsschritt, bei dem eine Nickel-Zinn-Chromlegierungsschicht auf einer Fläche der leitfähigen Beschichtungsschicht gebildet wird und
einen Entfernungsschritt, bei dem die poröse Basis entfernt wird.

12. Verfahren zum Herstellen des porösen Metallkörpers einer Nickel-Zinn-Chromlegierung gemäß einem der Ansprüche 1 bis 2, umfassend:
einen Schritt der Bildung einer leitfähigen Beschichtungsschicht auf einer Fläche einer aus einem Harzmaterial gebildeten porösen Basis;
einen Metallschichtbildungsschritt, bei dem eine Nickelschicht und eine Zinnschicht in einer beliebigen Reihenfolge auf einer Fläche der leitfähigen Beschichtungsschicht gebildet werden;
einen Entfernungsschritt, bei dem die poröse Basis entfernt wird; und
nachdem der Entfernungsschritt durchgeführt wird, um die poröse Basis zu entfernen, einen Verchromungsbehandlungsschritt, bei dem eine Verchromungsbehandlung durchgeführt wird.

13. Verfahren zum Herstellen des porösen Metallkörpers einer Nickel-Zinn-Chromlegierung gemäß einem der Ansprüche 1 bis 2, umfassend:
einen Schritt der Bildung einer leitfähigen Beschichtungsschicht, bei dem eine zinnhaltige leitfähige Beschichtungsschicht auf einer Fläche einer aus einem Harzmaterial gebildeten porösen Basis gebildet wird;
einen Metallschichtbildungsschritt, bei dem eine Nickelschicht auf einer Fläche der leitfähigen Beschichtungsschicht gebildet wird;
einen Entfernungsschritt, bei dem die poröse Basis entfernt wird; und
nachdem der Entfernungsschritt durchgeführt wird, um die poröse Basis zu entfernen, einen Verchromungsbehandlungsschritt, bei dem eine Verchromungsbehandlung durchgeführt wird.

## Revendications

1. Corps métallique poreux en alliage de nickel-étain-chrome pour un collecteur dans une batterie, un condensateur ou une pile à combustible comprenant du nickel, de l'étain, et du chrome, et, facultativement en tant qu'élément supplémentaire, au moins un élément sélectionné dans le groupe constitué du phosphore, du bore, de l'aluminium, du titane, du manganèse, du cobalt, du cuivre, du molybdène, et du tungstène,
dans lequel un rapport en poids entre l'élément supplémentaire et le corps métallique poreux est de 15 % en poids ou moins,
dans lequel un rapport en poids entre l'étain contenu dans le corps métallique poreux et le corps métallique poreux est de 12 % en poids ou plus et de 25 % en poids ou moins,
dans lequel un rapport en poids entre le chrome contenu dans le corps métallique poreux et le corps métallique poreux est de 1 % en poids ou plus et de 45 % en poids ou moins, et
dans lequel le corps métallique poreux est un corps structurel métallique ayant un squelette en réseau tridimensionnel.

2. Corps métallique poreux en alliage de nickel-étain-chrome selon la revendication 1, dans lequel
un rapport en poids entre le chrome contenu dans le corps métallique poreux et le corps métallique poreux est de 5 % en poids ou plus et de 20 % en poids ou moins.

3. Procédé de production du corps métallique poreux en alliage de nickel-étain-chrome selon l'une quelconque des revendications 1 à 2, comprenant :
une étape de formation de couche de revêtement conducteur pour former une couche de revêtement conducteur contenant du chrome sur une surface d'une base poreuse formée d'un matériau de résine ;
une étape de formation de couche métallique pour former une couche de nickel et une couche d'étain dans n'importe quel ordre sur une surface de la couche de revêtement conducteur ;
une étape d'élimination pour éliminer la base poreuse ; et
une étape de diffusion pour, par un traitement thermique, provoquer une interdiffusion d'atomes métalliques entre la couche de nickel et la couche d'étain et diffuser le chrome contenu dans la couche de revêtement conducteur dans la couche de nickel et la couche d'étain.

4. Procédé de production du corps métallique poreux en alliage de nickel-étain-chrome selon l'une quelconque des revendications 1 à 2, comprenant :
une étape de formation de couche de revêtement conducteur pour former une couche de revêtement conducteur contenant de l'étain sur une surface d'une base poreuse formée d'un matériau de résine ;
une étape de formation de couche métallique pour former une couche de nickel et une couche de chrome dans n'importe quel ordre sur une surface de la couche de revêtement conducteur ;
une étape d'élimination pour éliminer la base poreuse ; et
une étape de diffusion pour, par un traitement thermique, provoquer une interdiffusion d'atomes métalliques entre la couche de nickel et la couche de chrome et diffuser l'étain contenu dans la couche de revêtement conducteur dans la couche de nickel et la couche de chrome.

5. Procédé de production du corps métallique poreux en alliage de nickel-étain-chrome selon l'une quelconque des revendications 1 à 2, comprenant :
une étape de formation de couche de revêtement conducteur pour former une couche de revêtement conducteur contenant de l'étain et du chrome sur une surface d'une base poreuse formée d'un matériau de résine ;
une étape de formation de couche métallique pour former une couche de nickel sur une surface de la couche de revêtement conducteur ;
une étape d'élimination pour éliminer la base poreuse ; et
une étape de diffusion pour, par un traitement thermique, diffuser l'étain et le chrome contenus dans la couche de revêtement conducteur dans la couche de nickel.

6. Procédé de production du corps métallique poreux en alliage de nickel-étain-chrome selon l'une quelconque des revendications 1 à 2, comprenant :
une étape de formation de couche de revêtement conducteur pour former une couche de revêtement conducteur sur une surface d'une base poreuse formée d'un matériau de résine ;
une étape de formation de couche métallique pour former une couche de nickel, une couche d'étain, et une couche de chrome dans n'importe quel ordre sur une surface de la couche de revêtement conducteur ;
une étape d'élimination pour éliminer la base poreuse ; et
une étape de diffusion pour, par un traitement thermique, provoquer une interdiffusion d'atomes métalliques entre la couche de nickel, la couche d'étain, et la couche de chrome.

7. Procédé de production du corps métallique poreux en alliage de nickel-étain-chrome selon l'une quelconque des revendications 1 à 2, comprenant :
une étape de formation de couche de revêtement conducteur pour former une couche de revêtement conducteur sur une surface d'une base poreuse formée d'un matériau de résine ;
une étape de formation de couche métallique pour former une couche en alliage de nickel-étain et une couche de chrome dans n'importe quel ordre sur une surface de la couche de revêtement conducteur ;
une étape d'élimination pour éliminer la base poreuse ; et
une étape de diffusion pour, par un traitement thermique, provoquer une interdiffusion d'atomes métalliques entre la couche en alliage de nickel-étain et la couche de chrome.

8. Procédé de production du corps métallique poreux en alliage de nickel-étain-chrome selon l'une quelconque des revendications 1 à 2, comprenant :
une étape de formation de couche de revêtement conducteur pour former une couche de revêtement conducteur sur une surface d'une base poreuse formée d'un matériau de résine ;
une étape de formation de couche métallique pour former une couche en alliage de nickel-chrome et une couche d'étain dans n'importe quel ordre sur une surface de la couche de revêtement conducteur ;
une étape d'élimination pour éliminer la base poreuse ; et
une étape de diffusion pour, par un traitement thermique, provoquer une interdiffusion d'atomes métalliques entre la couche en alliage de nickel-chrome et la couche d'étain.

9. Procédé de production du corps métallique poreux en alliage de nickel-étain-chrome selon l'une quelconque des revendications 1 à 2, comprenant :
une étape de formation de couche de revêtement conducteur pour former une couche de revêtement conducteur contenant de l'étain sur une surface d'une base poreuse formée d'un matériau de résine ;
une étape de formation de couche métallique pour former une couche en alliage de nickel-chrome sur une surface de la couche de revêtement conducteur ;
une étape d'élimination pour éliminer la base poreuse ; et
une étape de diffusion pour, par un traitement thermique, diffuser l'étain contenu dans la couche de revêtement conducteur dans la couche en alliage de nickel-chrome.

10. Procédé de production du corps métallique poreux en alliage de nickel-étain-chrome selon l'une quelconque des revendications 1 à 2, comprenant :
une étape de formation de couche de revêtement conducteur pour former une couche de revêtement conducteur contenant du chrome sur une surface d'une base poreuse formée d'un matériau de résine ;
une étape de formation de couche métallique pour former une couche en alliage de nickel-étain sur une surface de la couche de revêtement conducteur ;
une étape d'élimination pour éliminer la base poreuse ; et
une étape de diffusion pour, par un traitement thermique, diffuser le chrome contenu dans la couche de revêtement conducteur dans la couche en alliage de nickel-étain.

11. Procédé de production du corps métallique poreux en alliage de nickel-étain-chrome selon l'une quelconque des revendications 1 à 2, comprenant :
une étape de formation de couche de revêtement conducteur pour former une couche de revêtement conducteur sur une surface d'une base poreuse formée d'un matériau de résine ;
une étape de formation de couche métallique pour former une couche en alliage de nickel-étain-chrome sur une surface de la couche de revêtement conducteur ; et
une étape d'élimination pour éliminer la base poreuse.

12. Procédé de production du corps métallique poreux en alliage de nickel-étain-chrome selon l'une quelconque des revendications 1 à 2, comprenant :
une étape de formation de couche de revêtement conducteur pour former une couche de revêtement conducteur sur une surface d'une base poreuse formée d'un matériau de résine ;
une étape de formation de couche métallique pour former une couche de nickel et une couche d'étain dans n'importe quel ordre sur une surface de la couche de revêtement conducteur ;
une étape d'élimination pour éliminer la base poreuse ; et
après que l'étape d'élimination est effectuée pour éliminer la base poreuse, une étape de traitement de chromisation pour effectuer un traitement de chromisation.

13. Procédé de production du corps métallique poreux en alliage de nickel-étain-chrome selon l'une quelconque des revendications 1 à 2, comprenant :
une étape de formation de couche de revêtement conducteur pour former une couche de revêtement conducteur contenant de l'étain sur une surface d'une base poreuse formée d'un matériau de résine ;
une étape de formation de couche métallique pour former une couche de nickel sur une surface de la couche de revêtement conducteur ;
une étape d'élimination pour éliminer la base poreuse ; et
après que l'étape d'élimination est effectuée pour éliminer la base poreuse, une étape de traitement de chromisation pour effectuer un traitement de chromisation.
